# EUROPÄISCHE PATENTANMELDUNG

(11) **EP 4 113 632 A1**
(43) Veröffentlichungstag der Anmeldung: **04.01.2023**
(21) Anmeldenummer: 21182120.2
(22) Anmeldetag: 28.06.2021
(51) Int. Cl.: H01L 31/05, H01L 31/042

(54) **PHOTOVOLTAIKMODUL**

(71) Anmelder: Heckert Solar GmbH, 09116 Chemnitz (DE)
(72) Erfinder: KÖHLER, Ronny, 09337 Hohenstein-Ernstthal (DE); TRINKERL, Benjamin, 01465 Dresden-Langebrück (DE)
(74) Vertreter: Zimmermann & Partner Patentanwälte mbB

(57) **Zusammenfassung**

Ein Photovoltaikmodul weist Folgendes auf: Einen in einer Aufsicht zumindest im Wesentlichen rechteckigen äußeren Rahmen (111, 211), aufweisend zwei erste Rahmenkanten (101, 201) einer ersten Rahmenkantenlänge (L) und zwei zweite Rahmenkanten (102, 202) einer zweiten Rahmenkantenlänge (B), die geringer als die erste Rahmenkantenlänge ist (L); in der Aufsicht in mehreren Reihen (S₁-S₈) angeordnete und zumindest im Wesentlichen rechteckige photovoltaische Zellen (10) jeweils aufweisend zwei erste Zellenkanten (11) einer ersten Zellenkantenlänge (1), die zumindest im Wesentlichen in eine zu den ersten Rahmenkanten (101, 201) parallele erste Richtung (x) orientiert sind, und zwei zweite Zellenkanten (12) einer zweiten Zellenkantenlänge (b), die geringer als die erste Zellenkantenlänge (1) ist; zwei Gruppen von in der Aufsicht jeweils zumindest im Wesentlichen in die erste Richtung (x) orientierten Querverbindern (121-125, 221-225), wobei die Querverbinder (121-125, 221-225) in jeder der zwei Gruppen in der ersten Richtung (x) voneinander beabstandet sind, und die Querverbinder (121-123, 221-223) einer ersten Gruppe der zwei Gruppen in eine zur ersten Richtung (x) senkrechten zweiten Richtung (y) von den Querverbindern (124-125, 224-225) einer zweiten Gruppe der zwei Gruppen beabstandet sind; in der Aufsicht jeweils zumindest im Wesentlichen in die zweite Richtung (y) orientierte Längsverbinderanordnungen (114, 214, 324, 424, 425, 625, 735, 835), wobei jede der Längsverbinderanordnungen einen Querverbinder (121-123, 221-223) der ersten Gruppe mit den photovoltaischen Zellen (10) einer der Reihen (S₁ - S₈) und einem Querverbinder (124-125, 224-225) der zweiten Gruppe elektrisch verbindet; und zwei, in der Aufsicht zumindest bezüglich der ersten Richtung (x) dezentral angeordnete Leistungsanschlüsse (D1, D2) zum elektrischen Verbinden einer externen Last oder eines Umrichters mit den Querverbindern (121-123) der ersten Gruppe.

## Beschreibung

Die vorliegende Erfindung betrifft eine Photovoltaikmodul, insbesondere ein Photovoltaikmodul für eine Photovoltaikanlage eines Dachs.

Photovoltaikanlagen bestehen üblicherweise aus miteinander verschalteten photovoltaischen Zellen, die auch als Solarzellen bezeichnet werden und deren prinzipieller Aufbau (sandwichartige Schichtstruktur) an sich bekannt ist, sowie einem Stromwandler. Beispielsweise kann es sich um eine Silicium-Solarzelle handeln. Bei einer netzgekoppelten Photovoltaikanlage kann mit Hilfe eines Wechselrichters der in den photovoltaischen Zellen im Betrieb entstehende Gleichstrom in Wechselstrom gewandelt und ins Stromnetz eingespeist werden. Um eine jeweilige gewünschte Mindesteingangsspannung am Wechselrichter zu erreichen, kann eine entsprechende Anzahl von photovoltaischen Zellen in Reihe geschaltet werden. Da der Strom der Reihenschaltung durch die photovoltaische Zelle mit der geringsten Stromabgabe begrenzt wird, werden die photovoltaischen Zelle typischerweise gleich ausgelegt und sollten im Betrieb möglichst der gleichen Strahlungsleistung ausgesetzt sein. Typischerweise werden zudem mehrere photovoltaische Zellen zu einem Photovoltaikmodul zusammengefasst, dass auch als Solarmodul bezeichnet wird. Mehrere in Reihe geschaltete Zellen eines Photovoltaikmoduls werden auch als Modulstrang oder Modulstring bezeichnet. Neben der Eingangsspannung ist insbesondere für netzgekoppelte Photovoltaikanlagen auch der Eingangsstrom in den Wechselrichter von Bedeutung.

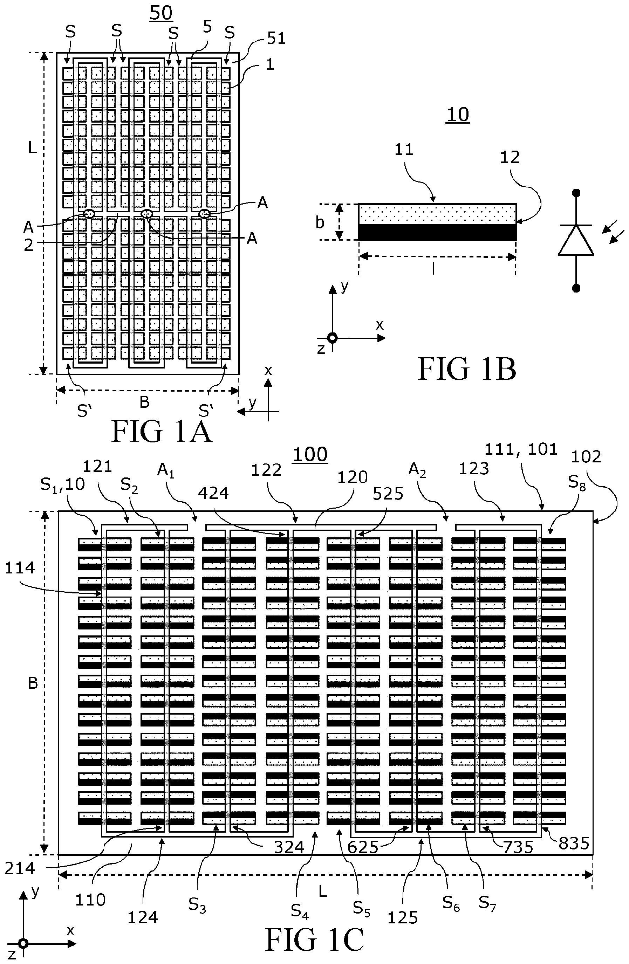

Figur 1A zeigt ein häufig verwendetes rechteckiges Photovoltaikmodul 50, bei dem ein sogenanntes "butterfly"-Layout (Anordnung bzw. Verschaltung) photovoltaischer Halbzellen 1 in Modulsträngen S, S' verwendet wird. Beim Modul 50 wird der im Betrieb von den 120 Halbzellen erzeugte Strom mittels dreier Anschlussdosen A abgeführt, die auf einem Mittelsteg 2 der elektrischen Verbinder 5 bzw. einer zentralen (Spiegel-) Symmetrieachse zwischen den Modulsträngen S, S' angeordnet sind. Diese kombinierte Reihen-Parallel-Verschaltung benötigt jedoch relativ viel Material und Lötpunkte, was sich nicht nur auf die Kosten sondern auch auf die Leitungslängen (Widerstände), die Langzeitstabilität im Betrieb, die Effizienz und/oder den ökologischen Gesamtabdruck des Photovoltaikmoduls 50 negativ auswirken kann. Andere Photovoltaikmodule verwenden insbesondere auf Grund der erwarteten Gesamteffizienz bei der Stromerzeugung eine reine Reihenverschaltung (Serienverschaltung) der photovoltaischen Zellen.

Im Hinblick auf das oben Gesagte, schlägt die vorliegende Erfindung ein Photovoltaikmodul gemäß Anspruch 1 vor.

Gemäß einem Ausführungsbeispiel weist ein Photovoltaikmodul einen in einer Aufsicht zumindest im Wesentlichen rechteckigen äußeren Rahmen mit zwei erste Rahmenkanten einer ersten Rahmenkantenlänge und zwei zweiten Rahmenkanten einer zweiten Rahmenkantenlänge, die geringer als die erste Rahmenkantenlänge ist, auf. Das Photovoltaikmodul weist in der Aufsicht in mehreren Reihen angeordnete und zumindest im Wesentlichen rechteckige photovoltaische Zellen mit jeweils zwei ersten Zellenkanten einer ersten Zellenkantenlänge, die zumindest im Wesentlichen in eine zu den ersten Rahmenkanten parallele erste Richtung orientiert sind, und mit zwei zweiten Zellenkanten einer zweiten Zellenkantenlänge, die geringer als die erste Zellenkantenlänge ist, auf. Außerdem weist das Photovoltaikmodul zwei Gruppen von in der Aufsicht jeweils zumindest im Wesentlichen in die erste Richtung orientierten Querverbindern, in der Aufsicht typischerweise jeweils zumindest im Wesentlichen in die zweite Richtung orientierte Längsverbinderanordnungen, und zwei, in der Aufsicht zumindest bezüglich der ersten Richtung dezentral angeordnete Leistungsanschlüsse zum elektrischen Verbinden einer externen Last oder eines Umrichters mit den Querverbindern einer ersten Gruppe der Querverbinder auf. Die Querverbinder in jeder der zwei Gruppen sind in der ersten Richtung voneinander beabstandet. Die Querverbinder der ersten Gruppe sind in eine zur ersten senkrechten zweiten Richtung von den Querverbindern einer zweiten Gruppe der zwei Gruppen von Querverbindern beabstandet. Jede der Längsverbinderanordnungen verbindet einen Querverbinder der ersten Gruppe mit den photovoltaischen Zellen einer der Reihen und einem Querverbinder der zweiten Gruppe elektrisch.

Die Querverbinder und die Längsverbinderanordnungen können eine Leitungsverbinderanordnung für das Photovoltaikmodul bilden. Die Längsverbinderanordnungen können eine Zellverbinderanordnung (der Leitungsverbinderanordnung) bilden, die einsprechend der Anordnung der photovoltaischen Zellen in Reihen mehrere Reihen von Längsverbinderanordnungen aufweisen kann.

Die Zellverbinderanordnung bzw. jede der Längsverbinderanordnungen besteht typischerweise aus mehreren jeweiligen Abschnitten, die zumindest im Wesentlichen in die zweite Richtung orientiert sein können und die jeweils zwei benachbarte photovoltaische Zellen einer Reihe miteinander oder eine äußere der photovoltaischen Zellen mit dem jeweiligen Querverbinder elektrisch verbinden. Typischerweise weist jede der Längsverbinderanordnungen mehrere, in der Aufsicht in die zweite Richtung in Reihe (hintereinander) angeordnete (beabstandete) Abschnitte auf oder besteht aus diesen Abschnitten, noch typischer aus m+1 Abschnitten, wobei m die Anzahl der photovoltaischen Zellen in einer bzw. jeder der Reihen ist.

Die hierin verwendeten Formulierungen "im Wesentlichen rechteckigen" bzw. "im Wesentlichen rechteckiger äußerer Rahmen" soll auch entsprechende Formen mit vier Seitenkanten, aber abgerundeten oder abgeschrägten Eckbereichen umfassen. Dies gilt nicht nur für den Rahmen, sondern auch für die photovoltaischen Zellen, die in Eckbereichen ebenfalls abgerundet sein können, wie z.B. eine Silicium-Solarzelle im PERC-Design ("passivated emitter and rear cell"-Design) mit fingerförmigen Kontakten auf der Rückseite. Ein den Rahmen bzw. die photovoltaische Zelle in der Aufsicht minimal umgebendes Rechteck ist aber nichtquadratisch.

Die hierin verwendeten Formulierungen "im Wesentlichen senkrecht" und "im Wesentlichen parallel" können sich auch auf eine mittlere jeweilige Orientierung beziehen und/oder sollen Abweichungen von maximal wenigen Grad, insbesondere maximal 10°, z.B. maximal 5°, typischer maximal 2° umfassen.

Im Vergleich zum "butterfly"-Layout ergeben sich eine Reihe von Vorteilen.

Das Photovoltaikmodul im hierin vorgeschlagenen Layout kann sehr kompakt (zumindest kompakter als beim "butterfly"-Layout) mit z.B. einer Modulbreite von nur knapp 68% (Faktor 1,14/1,33) im Vergleich zum "butterfly"-Layout realisiert werden, bei Verwendung desselben Zellformates G12, wodurch das Modul auch für einen Installateur, insbesondere bei einer Installation oder einem Austausch auf einem Häuserdach besser handhabbar wird. Ebenso beträgt durch die kompakteren Modulmaße das Modulgewicht 68% im Vergleich zum Butterfly Layout.

Ein weiterer Vorteil besteht darin, dass der zu erwartende Leistungsverlust bei den hierin beschriebenen Photovoltaikmodulen bei Abschattung entlang der kürzeren der (zweiten) Rahmenkanten eines PV-Moduls deutlich geringer (bis zu ca. 50%) als bei einem Butterfly-Modul (bis zu ca. 100%) ausfällt.

Außerdem werden nur zwei Anschlussdosen benötigt, was mit einer Materialreduktion und einem verringertem Fertigungsaufwand einhergeht.

Zudem ist das vorgeschlagene Design variabel verwendbar für Halb- und Drittelzellen. Im Folgenden werden die photovoltaischen Zellen auch als Photovoltaikzellen und kurz auch als Zellen bezeichnet.

Weiterhin kann im Vergleich zum "butterfly"-Layout durch Verzicht auf den Mittelsteg die Anzahl der Lötpunkte deutlich reduziert werden (von bspw. 288 auf 192 für ein Photovoltaikmodul mit 120 Zellen und vier Paaren parallel geschalteten Reihen). Dies führt nicht nur zu weiteren Kosteneinsparungen, sondern bietet auch einen Qualitätsvorteil, da das Risiko für kalte Lötstellen entsprechend reduziert wird (typischerweise um ca. 33,3%).

Außerdem zeigt sich, dass die Photovoltaikzellen weniger (nur vgl. sehr geringen) mechanischen Belastungen im Betrieb ausgesetzt sind. Entsprechend kann die Zellbruchgefahr und der mechanische Stress auf die Zellverbinderübergänge reduziert werden. Dies trifft insbesondere auf mechanische Belastungen durch Schnee- und Windlasten zu, die zu einer Verbiegung des Photovoltaikmoduls führen können. Die damit einhergehenden mechanischen Spannungen können zu Defekten (Lötestellendefekte, Zellbruch, etc.) führen, wodurch eine Leistungsminderung hervorrufen werden kann. Dass die mechanischen Spannungen in den Photovoltaikzellen bei dem hierin beschriebenen Photovoltaikmodul geringer ausfallen, liegt wesentlich daran, dass die längeren (ersten) Rahmenkanten des Photovoltaikmoduls (zumindest im Wesentlichen parallel) zu den längeren (ersten) Zellenkanten der Photovoltaikzellen ausgerichtet sind. Da das Photovoltaikmodul die stärkste Biegung typischerweise über seine längere Rahmenkante erfährt, und die Querverbinder senkrecht zur längeren Rahmenkante orientiert sind, werden diese bei Verbiegung des Photovoltaikmoduls zudem auch kaum longitudinal gestreckt. Somit können mechanische Spannungen in Kontaktstellen (bspw. Lötkontakten) reduziert werden.

Weiterhin weist das vorgeschlagene und im Folgenden detaillierter beschriebene Layout eine sehr einfache, robuste und effiziente Verschaltung der Zellen auf.

Bei den typischerweise zumindest im Wesentlichen identisch ausgeführten Photovoltaikzellen kann es sich insbesondere um sogenannte Rückkontaktphotovoltaikzellen handeln.

Außerdem sind die photovoltaischen Zellen typischerweise entweder Halbzellen oder Drittelzellen, z.B. gedrittelte G12-Zellen. Andere (geteilte) Photovoltaikzellen können aber ebenfalls verwendet werden. Das Verhältnis von zweiter Zellenkantenlänge zur ersten Zellenkantenlänge beträgt für Halbzellen 1/2 und für Drittelzellen 1/3.

Insbesondere kann jede der Reihen (mindestens) sechs Halbzellen, typischerweise zehn Halbzellen oder (mindestens) zehn Drittelzellen, typischerweise fünfzehn Drittelzellen aufweisen.

Typischerweise weist jede der Reihen höchstens fünfzehn Halbzellen oder höchstens einundzwanzig Drittelzellen auf.

Die erste Gruppe der Querverbinder weist typischerweise einen ersten Querverbinder, einen zweiten Querverbinder, und einen dritten Querverbinder auf.

Die zweite Gruppe der Querverbinder weist typischerweise einen vierten Querverbinder und einen fünften Querverbinder aufweist.

Die Querverbinder der ersten Gruppe, insbesondere der erste Querverbinder, der zweite Querverbinder, und der dritte Querverbinder können in der Aufsicht auf einer ersten Linie (und typischerweise jeweils dazu parallel orientiert) angeordnet sind, die zumindest im Wesentlichen parallel zur ersten Richtung.

Analog dazu können die Querverbinder der zweiten Gruppe, insbesondere der vierte Querverbinder und der fünfte Querverbinder in der Aufsicht auf einer zweiten Linie (und typischerweise jeweils dazu parallel orientiert) angeordnet sein, die zumindest im Wesentlichen parallel zur ersten Richtung ist.

Die erste Linie kann in der Aufsicht näher an einer ersten der zwei ersten Rahmenkanten des Rahmens als an einer dazu typischerweise parallelen Mittellinie zwischen den ersten Rahmenkanten des Rahmens liegen.

Die zweite Linie kann in der Aufsicht näher an einer zweiten der zwei ersten Rahmenkanten des Rahmens als an der Mittellinie liegt.

Zudem sind die meisten oder sogar alle photovoltaischen Zellen der Reihen in der Aufsicht typischerweise zumindest teilweise, typischer größtenteils, noch typischer vollständig zwischen der ersten Linie und der zweiten Linie angeordnet.

Außerdem können (mindestens) zwei erste Längsverbinderanordnungen vorgesehen sein, wobei jede der zwei ersten Längsverbinderanordnungen die photovoltaischen Zellen einer Reihe zweier erster Reihen photovoltaischer Zellen miteinander und mit dem ersten Querverbinder und dem vierten Querverbinder elektrisch verbindet.

Weiterhin können (mindestens) zwei zweite Längsverbinderanordnungen vorgesehen sein, wobei jede der zwei zweiten Längsverbinderanordnungen die photovoltaischen Zellen einer Reihe zweier zweiter Reihen photovoltaischer Zellen miteinander und mit dem zweiten Querverbinder und dem vierten Querverbinder elektrisch verbindet.

Entsprechend können (mindestens) zwei dritte Längsverbinderanordnungen vorgesehen sein, wobei jede der zwei dritten Längsverbinderanordnungen die photovoltaischen Zellen einer Reihe zweier dritter Reihen photovoltaischer Zellen miteinander und mit dem zweiten Querverbinder und dem fünften Querverbinder verbindet, und/oder zwei vierte Längsverbinderanordnungen vorgesehen sei, wobei jede der zwei vierten Längsverbinderanordnungen die photovoltaischen Zellen einer Reihe zweier vierter Reihen photovoltaischer Zellen miteinander und mit dem dritten Querverbinder und dem fünften Querverbinder verbinden.

Dementsprechend kann das Photovoltaikmodul in der Aufsicht acht Reihen photovoltaische Zellen aufweisen. Das Photovoltaikmodul kann insbesondere auch nur acht Reihen (Modulstränge) aufweisen.

Photovoltaikmodule mit mehr als acht Reihen sind aber auch möglich, was bei gleicher Auslegung der photovoltaischen Zellen aber zu einer größeren ersten Rahmenkantenlänge führt. Außerdem können dann auch mehr Anschlüsse erforderlich sein, typischerweise jedoch z.B. höchstens ein Anschluss für vier Reihen von photovoltaischen Zellen mit typischerweise jeweils 10 Halbzellen oder 15 Drittelzellen.

Jede der zwei ersten, zwei zweiten, zwei dritten und zwei vierten Längsverbinderanordnungen (Zellverbinder) besteht typischerweise aus mehreren jeweiligen Abschnitten, die in der Aufsicht zumindest im Wesentlichen in die zweite Richtung orientiert sein können und die jeweils zwei benachbarte photovoltaische Zellen einer Reihe miteinander oder eine äußere der photovoltaischen Zellen mit einem jeweiligen Querverbinder elektrisch verbinden. Typischerweise weist jede der zwei ersten, zwei zweiten, zwei dritten und zwei vierten Längsverbinderanordnungen mehrere, in der Aufsicht in die zweite Richtung in Reihe (hintereinander) angeordnete (beabstandete) Abschnitte auf oder besteht aus diesen Abschnitten, noch typischer aus m+1 Abschnitten, wobei m die Anzahl der photovoltaischen Zellen in einer bzw. jeder der Reihen ist.

Die photovoltaischen Zellen einer jeden Reihe können untereinander und mit den jeweiligen zwei Querverbindern auch über mehr als zwei Längsverbinderanordnungen elektrisch verbunden sein.

Da die photovoltaischen Zellen jeder der Reihen über (mindestens) eine jeweilige Längsverbinderanordnung in Reihe geschaltet sind und jeweils (mindestens) zwei (erste bis vierte) Reihen zwischen den Querverbinder parallel zueinander geschaltet sind, ergibt sich eine besonders effektive Verschaltung bei hoher Flächenausnutzung.

Jeder der Querverbinder der ersten Gruppe kann über k*N Längsverbinderanordnungen mit N (parallel geschalteten) Reihen der photovoltaischen Zellen und einem bzw. dem jeweiligen Querverbinder der zweiten Gruppe elektrisch verbunden sein, wobei k eine positive ganze Zahl und N eine ganze Zahl größer als eins ist. Insbesondere kann N zwei oder drei, aber auch größer sein. Die Zahl k repräsentiert die Anzahl der Längsverbinderanordnungen pro Reihe photovoltaischer Zellen und liegt typischerweise in einem Bereich von 2 bis 35, noch typischer in einem Bereich von fünf bis fünfzehn.

Insbesondere können N erste Reihen parallel geschaltet sein, N zweite Reihen parallel geschaltet sein, N dritte Reihen parallel geschaltet sein, N vierte Reihen parallel geschaltet sein, und/oder die photovoltaischen Zellen der N ersten Reihen in Reihe mit den photovoltaischen Zellen der N zweiten Reihen, mit den photovoltaischen Zellen der N dritten Reihen und mit den photovoltaischen Zellen der N vierten Reihen in Reihe geschaltet sein.

Wenn N=2 (N=3) ist, können dementsprechend zwei (drei) erste Reihen parallel geschaltet sein, zwei (drei) zweite Reihen parallel geschaltet sein, zwei (drei) dritte Reihen parallel geschaltet sein, zwei (drei) vierte Reihen parallel geschaltet sein, und die ersten Reihen in Reihe mit den zweiten Reihen, mit den dritten Reihen und mit den vierten Reihen geschaltet sein.

Typischerweise werden in Photovoltaikmodulen mit jeweils zwei oder drei parallel geschalteter (erster bis vierter oder sogar noch mehr) Reihen (N=2, 3) Halbzellen, oder Drittelzellen eingesetzt.

Wie bereits oben erwähnt wurde, kann jede der Längsverbinderanordnungen aus m+1 Abschnitten gebildet sein, wobei m die Anzahl der photovoltaischen Zellen in einer bzw. jeder der Reihen ist. Die Gesamtzahl der Abschnitte (Verbinder der Zellverbinderanordnung bzw. der Längsverbinderanordnungen), im Folgenden auch als Längsverbinder und Längsverbinderabschnitte bzw. Zellverbinder und Zellverbinderabschnitte bezeichnet, des Photovoltaikmoduls kann dementsprechend k*N*(m+1) betragen.

Der Rahmen kann aus (vier) Hohlkammerrahmenprofilen aufgebaut sein bzw. diese aufweisen. In der Aufsicht können die zwei ersten Rahmenkanten und die zwei zweiten Rahmenkanten des Rahmens eine Fläche von höchstens 4m², typischer höchstens 3,5 m² oder 3 m², noch typischer (insbesondere für ein Modul mit 120 Drittelzellen oder 80 Halbzellen) höchstens 2 m², z.B. höchstens 1,98 m² umschließen. Dies führt zu einer entsprechend hohen Flächenausnutzung. Dementsprechend kann der Rahmen eines Photovoltaikmodul je 60 Drittelzellen oder je 40 Halbzellen eine Fläche von höchstens 2 m², z.B. höchstens 1,98 m² umschließen.

Außerdem kann ein Verhältnis zwischen der ersten Länge der ersten Rahmenkanten und der zweiten Länge der zweiten Rahmenkanten des Rahmens in einem Bereich von 1,3 bis 1,9, typischer in einem Bereich 1,5 bis 1,6 liegen.

Ein Nennstrom des Photovoltaikmoduls kann in einem Bereich von etwa 3 A bis 29 A, z.B. in einem Bereich von etwa 3 A bis etwa 13 A liegen, insbesondere bei etwa 12,5 A betragen.

Abhängig vom Zellenformat kann der Nennstrom des Photovoltaikmoduls in folgenden Bereichen liegen:
4,6 A - 19, 1 A für N=2 und Halbzellen als photovoltaische Zellen,
3 A - 12,7 A für N=2 und Drittelzellen als photovoltaische Zellen, z.B. 12.6 A für IBC-Solarzellen,
6,9 A - 28,6 A für N=3 und Halbzellen als photovoltaische Zellen, sowie
4,6 A - 18,9 A für N=3 und Drittelzellen als photovoltaische Zellen.

Eine elektrische Nennleistung des Photovoltaikmoduls kann mindestens 380 W, mindestens 390 W oder sogar mindestens 400 W betragen.

Außerdem kann eine maximale flächenspezifische elektrische Leistungsdichte des Photovoltaikmoduls (bei einer typischen senkrechten Bestrahlung mit Sonnenlicht einer Leistungsdichte von bis zu 1 kW/m² größer als 190 W/m², größer als 195 W/m² oder sogar größer als 200 W/m² sein, beispielsweise etwa 205 W/m² betragen (Peakwert, oft auch als Wp/m² angegeben).

Die Leistungsanschlüsse sind typischerweise als jeweilige Anschlussdose ausgeführt.

Außerdem können die Leistungsanschlüsse für einen Rückstrom ausgelegt sein, der zumindest doppelt so groß wie der Nennstrom des Photovoltaikmoduls ist.

Typischerweise steht ein erster Leistungsanschluss der zwei Leistungsanschlüsse in ohmscher Verbindung mit dem ersten Querverbinder und ist mit dem zweiten Querverbinder über eine erste Leistungsdiode elektrisch verbunden.

Außerdem steht ein zweiter Leistungsanschluss der zwei Leistungsanschlüsse typischerweise in ohmscher Verbindung mit dem dritten Querverbinder und ist mit dem zweiten Querverbinder über eine zweite Leistungsdiode elektrisch verbunden.

Die erste Leistungsdiode und die zweite Leistungsdiode sind typischerweise in Reihe geschaltet.

Außerdem können die Leistungsdioden als Schottky-Dioden oder als gleichwirkende, elektrische Schaltungen ausgeführt sein.

Zumindest für Photovoltaikmodule mit (maximal) acht Reihen photovoltaische Zellen sind typischerweise weiteren Leistungsanschlüsse zum elektrischen Verbinden mit der externen Last oder dem Wechselrichter und/oder keine weitere Leistungsdioden vorgesehen.

Die zwei Leistungsanschlüsse sind in der Aufsicht typischerweise zumindest im Wesentlichen spiegelsymmetrisch zu einer in die zweite Richtung orientierten Mittellinie des Rahmens angeordnet.

Die zwei Leistungsanschlüsse können in der Aufsicht bezüglich der zweiten Richtung dezentral angeordnet sein, in einem Randbereich der mehreren Reihen, nahe einer der zwei erste Rahmenkanten, und/oder in der Aufsicht benachbart oder sogar auf einer zur ersten Richtung parallelen Linie angeordnet sein.

Gemäß einem Ausführungsbeispiel weist eine Photovoltaikanlage ein hierin beschriebenes Photovoltaikmodul auf.

Die Photovoltaikanlage kann mehrere, sogar eine Vielzahl der hierin beschriebenes Photovoltaikmodule aufweisen.

Außerdem kann die Photovoltaikanlage einen Wechselrichter aufweisen, der mit dem ersten Leistungsanschluss und dem zweiten Leistungsanschluss verbindbar ist.

Der Wechselrichter kann auch mit mehreren Photovoltaikmodulen verbunden werden bzw. verbindbar sein.

Alternativ oder ergänzend kann die Photovoltaikanlage einen elektrischen Energiespeicher, der mit dem ersten Leistungsanschluss und dem zweiten Leistungsanschluss verbindbar ist, aufweisen, z.B. ein oder mehrere wiederaufladbare Speicherelemente für elektrische Energie.

Gemäß noch einem Ausführungsbeispiel weist ein Set zum Aufbau einer Photovoltaikanlage, insbesondere zur Ausrüstung eines (Gebäude-) Dachs mit der Photovoltaikanlage ein oder sogar mehrere der hierin beschriebenen Photovoltaikmodule.

Die vorstehend beschriebenen Ausführungsformen können miteinander kombiniert werden.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:
Fig. 1A eine schematische Aufsicht eines typischen Photovoltaikmoduls;
Fig. 1B eine schematische Aufsicht einer Photovoltaikzelle;
Fig. 1C eine schematische Aufsicht eines Photovoltaikmoduls mit mehreren der in Fig. 1B dargestellten Photovoltaikzellen gemäß einem Ausführungsbeispiel;
Fig. 2A eine weitere schematische Aufsicht des in Fig. 1C dargestellten Photovoltaikmoduls gemäß einem Ausführungsbeispiel;
Fig. 2B und Fig. 2C Teile eines Schaltbildes des in Fig. 1C und Fig. 2A dargestellten Photovoltaikmoduls gemäß einem Ausführungsbeispiel;
Fig. 3A eine schematische Aufsicht eines Photovoltaikmoduls gemäß einem Ausführungsbeispiel; und
Fig. 3B eine schematische Darstellung einer Photovoltaikanlage gemäß einem Ausführungsbeispiel.

In den Figuren bezeichnen gleiche Bezugszeichen bzw. Bezugszeichen, deren letzte beiden Ziffern übereinstimmen entsprechend ähnliche Teile oder Elemente, die sogar identisch ausgeführt sein können.

Zur besseren Orientierung wird in einigen der Figuren zusätzlich ein kartesisches Koordinatensystem (x, y, z) gezeigt, wobei die z-Richtung die vertikale Richtung repräsentieren und die x- bzw. y-Richtung zueinander orthogonal horizontale Richtungen repräsentieren können.

Außerdem werden Stromflüsse während des Betriebs in einigen der Figuren durch gestrichelte Pfeile symbolisiert.

Fig. 1C zeigt eine schematische (nicht maßstabsgetreue) Sicht auf eine Unterseite bzw. Rückseite (schematische Rückseitenansicht) oder eine Oberseite bzw. Vorderseite eines Photovoltaikmoduls 100 mit 120 der in Fig. 1B dargestellten Photovoltaikzellen 10, die als Drittelzellen ausgeführt sind. Dementsprechend beträgt das Verhältnis der zweiten Zellenkantenlänge b der zweiten Zellenkanten 12 zur ersten Zellenkantenlänge 1 der ersten Zellenkanten 11 der rechteckigen photovoltaischen Zellen 10 ein Drittel. Außerdem wird im rechten Teil von Fig. 1B ein Schaltsymbol (Photodiode) für die Photovoltaikzellen 10 dargestellt, die mit der Schraffur der Photovoltaikzelle 10 im linken Teil von Fig. 1B korreliert. Dadurch lässt sich die vorgeschlagene Verschaltung in Fig. 1C besser nachvollziehen.

Aus Gründen der Übersichtlichkeit werden vom rechteckigen äußeren Rahmen 111 nur die zwei ersten Rahmenkanten 101 der ersten Rahmenkantenlänge L und die zwei zweite Rahmenkanten 102 der zweiten Rahmenkantenlänge B mit B < L dargestellt. Auch sind die Abstände zwischen den Photovoltaikzellen 10 aus Gründen der Übersichtlichkeit größer dargestellt und es wird abgesehen von den elektrischen Verbindern und einem exemplarischen Glasträger 110 auf weitere Details wie Folien und Einkapselungsmaterial etc. verzichtet.

Im Gegensatz zum in Fig. 1A dargestellten Modul 50 im "butterfly"-Design sind beim Photovoltaikmodul 100 die längeren Zellenkanten 11 zumindest im Wesentlichen, z.B. innerhalb von Fertigungsgenauigkeiten parallel zu den längeren Rahmenkanten 101 des Rahmens 111 orientiert.

In dem exemplarischen Ausführungsbeispiel hat das Photovoltaikmodul 100 acht parallel (zu den kürzeren Rahmenkanten 102, in y-Richtung) orientierte Reihen S₁-S₈ mit jeweils 15 über eine jeweilige Längsverbinderanordnung (Zellverbinderanordnung) 114, 214, 324, 424, 425, 625, 735, 835 in Reihe geschalteten Drittelzellen 10, die die Reihen S₁-S₈ zudem elektrisch mit jeweils zwei der fünf Querverbinder 121 - 125 verbinden.

Insbesondere gibt es zwei erste Längsverbinderanordnungen 114, 214, die jeweils die photovoltaischen Zellen 10 einer Reihe zweier erster Reihen S₁, S₂ miteinander und mit einem ersten Querverbinder 121 einer ersten Gruppe der Querverbinder und einem vierten Querverbinder 124 einer zweiten Gruppe der Querverbinder elektrisch verbinden, zwei zweite Längsverbinderanordnungen 324, 424, die jeweils die photovoltaischen Zellen 10 einer Reihe zweier zweiter Reihen S₃, S₄ miteinander und mit einem zweiten Querverbinder 122 der ersten Gruppe der Querverbinder und dem vierten Querverbinder 124 elektrisch verbinden, zwei dritte Längsverbinderanordnungen 525, 625, die jeweils die photovoltaischen Zellen 10 einer Reihe zweier dritter Reihen S₅, S₆ miteinander und mit dem zweiten Querverbinder 122 und einem fünften Querverbinder 125 der zweiten Gruppe der Querverbinder verbinden, und zwei vierte Längsverbinderanordnungen 735, 835, die jeweils die photovoltaischen Zellen 10 einer Reihe zweier vierter Reihen S₇, S₈ miteinander und mit einem dritten Querverbinder 123 der ersten Gruppe der Querverbinder und dem fünften Querverbinder 125 verbinden.

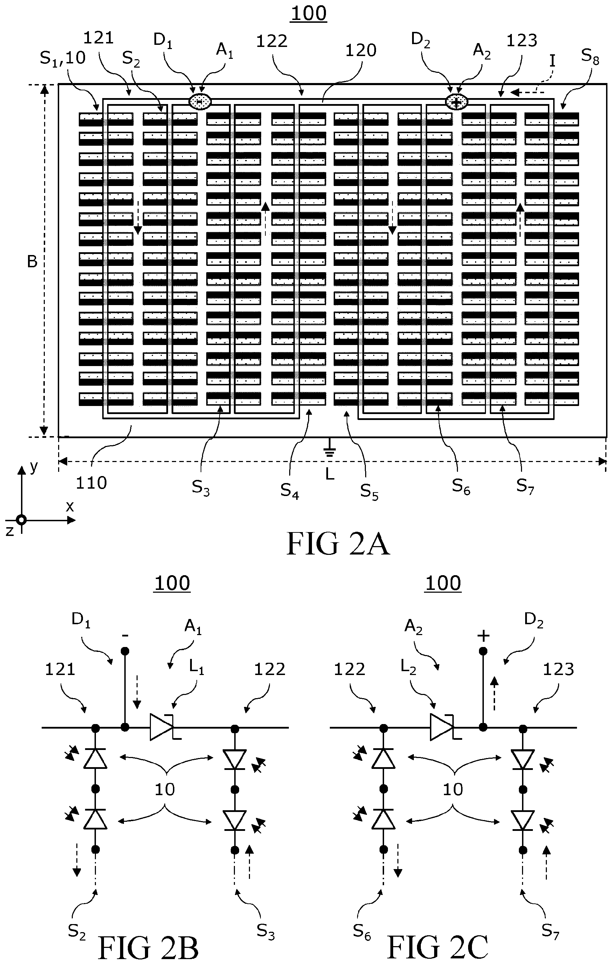

Fig. 2A zeigt eine weitere schematische Aufsicht (Rückseitenansicht) des in Fig. 1C dargestellten Photovoltaikmoduls 100, wobei in den beiden dezentralen Anschlussbereichen A₁, A₂ zusätzlich zwei typischerweise als Anschlussdose ausgeführte Leistungsanschlüsse D₁, D₂ mit ihrer jeweiligen Polung im Betrieb dargestellt werden.

Die Verschaltung des Moduls 100 und der Stromfluss (gestrichelte Pfeile) im Betrieb werden in Fig. 2B und Fig. 2C in Teilschaltbildern nahe der Anschlussbereiche A₁, A₂ zwischen dem ersten Querverbinder 121 und dem zweiten Querverbinder 122 (zwischen den Reihen S₂ und S₃) bzw. dem zweiten Querverbinder 122 und dem dritten Querverbinder 123 (zwischen den Reihen S₆ und S₇) dargestellt.

Zudem ist der erste Querverbinder 121 mit dem ersten Leistungsanschluss D₁ über eine erste Leistungsdiode L₁ mit dem zweiten Querverbinder 122 elektrisch verbunden, und der zweite Leistungsanschluss D₂ ist mit dem dritten Querverbinder 123 und über eine zweite Leistungsdiode L₂ mit dem zweiten Querverbinder 122 verbunden ist, sodass eine Anode der zweiten Leistungsdiode L₂ über den zweiten Querverbinder 122 mit einer Kathode der ersten Leistungsdiode L₁ in ohmscher Verbindung steht (gleichsinnige Reihenschaltung der Leistungsdioden L₁, L₂).

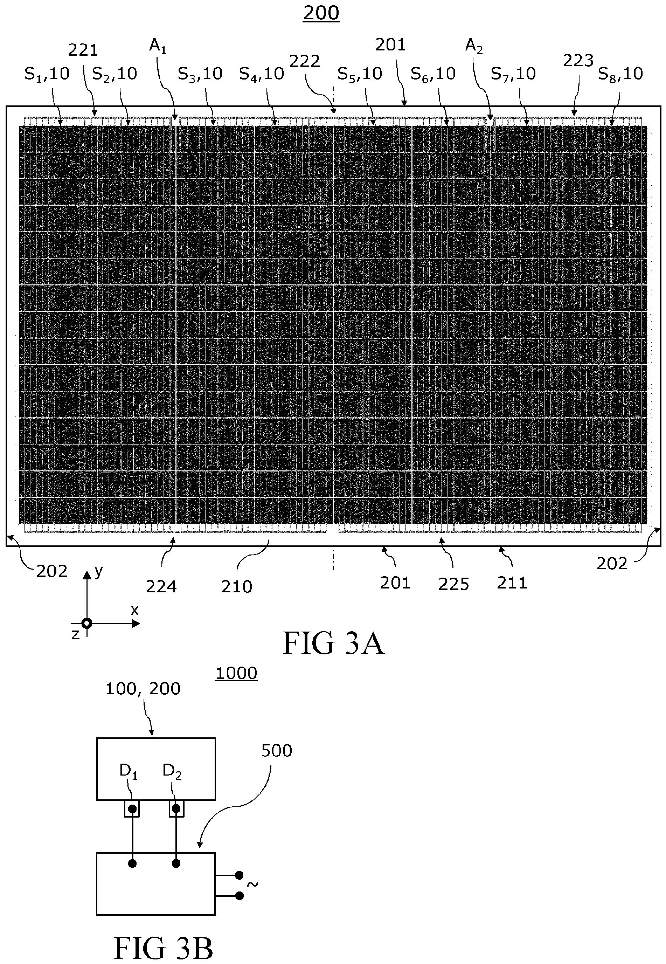

Fig. 3A zeigt eine schematische Sicht auf eine Unterseite (schematische Rückseitenansicht) eines Photovoltaikmoduls 200, das ähnlich wie das oben mit Bezug zu den Figuren 1B bis 2C erläuterte Modul 100 ist und ebenfalls über 120, in acht in y-Richtung orientierte Reihen S₁-S₈ mit je 15 angeordnete Drittelzellen 10 verfügt (m=15, N=2). Die Abstände zwischen den Zellen 10 zu den Querverbindern 221-225 sowie den ersten Rahmenkanten 201 und zweiten Rahmenkanten 202 des Rahmens 201 sind beim Modul 200 jedoch realistischer dargestellt.

Benachbarte photovoltaische Zellen können sogar überlappen und damit in der Aufsicht einen negativen Abstand aufweisen (Negative-Gap Verschaltung).

Außerdem sind die Zellen 10 jeder der acht Reihen S₁-S₈ des Moduls 200 über 12 exemplarische Längsverbinderanordnungen miteinander verbunden (k=12), die jeweils aus 16 Abschnitten besteht, wobei jeder der Abschnitte zwei, in Fig. 3A in y-Richtung untereinander angeordnete Zellen 10 einer Reihe S₁-S₈ miteinander oder eine äußere (oberste bzw. unterste) der Zellen 10 einer Reihe S₁-S₈ mit dem jeweils benachbarten Querverbinder 221-223 der ersten (oberen) Gruppe bzw. dem jeweils benachbarten Querverbinder 224, 225 der zweiten (unteren) Gruppe elektrisch verbinden, z.B. über entsprechende Verbindungsdrähte.

Die Gesamtzahl der Längsverbinderabschnitte ergibt sich in dem exemplarischen Ausführungsbeispiel zu N*k*(m+1) = 2*12*16=384 pro Doppelstring (d.h. pro Paar parallel geschalteter Reihen {S₁, S₂}, {S₃, S₄}, {S₅, S₆} und {S₇, S₈}), insgesamt also 1536=4^{∗}384.

Zudem sind die drei Querverbinder 221-223 der ersten Querverbindergruppe in den Anschlussbereichen A₁, A₂ jeweils L-förmig und dort teilweise über einen Randbereich einer jeweiligen (oberen) Zelle 10 verlaufend ausgeführt.

Dies ermöglicht die nichtdargestellten beiden Anschlussdosen in diesem Bereich und damit bei verringerter Fläche des Rahmens 211 hinreichend weit vom Rand bzw. der benachbarten ersten Rahmenkante 201 entfernt beabstandet vorzusehen.

Dies führt bei rückseitiger Bestrahlung zwar zu einer leichten Verschattung, bei Bestrahlung des Moduls 200 von der Vorderseite her lassen sich aber besonders hohe Leistungsdichten und Wirkungsgrade erzielen.

Bei einer äußeren Abmessung von L=1736 mm x B= 1138 mm ergeben sich dabei für 120 G12-Drittelzellen die folgenden Werte:

| | |
|---|---|
| Peakleistung: | 390-405 W, |
| Peakleistungsdichte: | 205 w/m², und |
| Wirkungsgrad: | 20,5 %, |

bei einem Strom von 12,5 A (je Leistungsanschluss).

Die Längsverbinderanordnungen bzw. deren Abschnitte können jeweils als Kupfer-Drähte mit einem Durchmesser von bspw. 0.4 mm zzgl. einer Lötschicht aber auch als entsprechende Flachdrähte ausgeführt sein.

Die Querverbinder können ebenfalls als Kupferdrähte, bspw. als 4 mm x 0.4 mm Kupferdrähte zzgl. einer Lötschicht ausgeführt sein.

Anstelle von Lötverbindungen zum Kontaktieren der Zellen 10 untereinander bzw. mit den Querverbindern können aber auch entsprechende Klebeverbindungen zu den Längsverbinderanordnungen vorgesehen werden.

Fig. 3B eine schematische Darstellung einer Photovoltaikanlage 1000. In dem exemplarischen Ausführungsbeispiel besteht die Photovoltaikanlage 1000 aus einem Photovoltaikmodul 100, 200, wie es oben mit Bezug zu den Figuren 1B bis 3A erläutert wurde, und einem Wechselrichter 500, dessen Eingänge mit den beiden Leistungsanschlüssen D₁, D₂ des Photovoltaikmoduls verbunden sind und dessen Ausgänge im Betrieb eine Wechselspannung ausgeben bzw. direkt in ein Netz oder über einen nichtdargestellten Transformator hochtransformiert in das Netz einspeisen können.

Alternativ oder ergänzend können die Leistungsanschlüsse D₁, D₂ auch mit einen elektrischen Energiespeicher wie einen Akkumulator verbunden sein, z.B. über einen Laderegler.

Ein oder mehrere der hierin beschriebenen Photovoltaikmodule 100, 200 können auch Teile eines Sets zum Aufbau einer Photovoltaikanlage 1000 darstellen, das darüber hinaus Befestigungsmittel für das Photovoltaikmodul bzw. die Photovoltaikmodule (auf einem Dach), Verbindungskabel, einen Wechselrichter und eine Aufbauanleitung enthalten kann.

Typischerweise werden die hierin beschriebenen Photovoltaikmodule 100, 200 als Glas-Folien-Aufbau realisiert. Es kann aber auch ein Glas-Glas-Aufbau verwendet werden.

Insbesondere bei Ausführungsformen im Glas-Glas-Aufbau ist es auch möglich, die drei Querverbinder der ersten Querverbindergruppe in den Anschlussbereichen ähnlich wie beim Photovoltaikmodul 200 auszuführen, jedoch so, dass die L-förmigen Abschnitte in der Aufsicht von den photovoltaische Zellen weg geführt werden (und diese daher auch nicht überlappen).

Dabei kann vorgesehen sein, die Leistungsanschlüsse an der benachbarten seitlichen längeren Kante (ersten Rahmenkante) des Photovoltaikmoduls anzuordnen.

Insbesondere bei einigen Ausführungsformen im Glas-Glas-Aufbau kann zumindest auf einen durchgehenden Rahmen verzichtet werden, auch wenn ein Rahmen aus Stabilitätsgründen Vorteile bietet. Auch für diese Ausführungsformen gelten die obigen Ausführungen zumindest im Wesentlichen, wobei die zwei erste Rahmenkanten einer ersten Rahmenkantenlänge und zwei zweite Rahmenkanten einer zweiten Rahmenkantenlänge, die geringer als die erste Rahmenkantenlänge ist, durch entsprechende Kanten eines Trägers des Photovoltaikmoduls, z.B. eines der Trägers des Photovoltaikmoduls, bzw. allgemeiner entsprechende seitliche Kanten des Photovoltaikmoduls zu ersetzen sind.

Dementsprechend kann gemäß einem Ausführungsbeispiel ein in einer Aufsicht typischerweise zumindest im Wesentlichen rechteckiges Photovoltaikmodul aufweisen:
zwei äußere erste Kanten einer ersten Kantenlänge und zwei äußere zweite Kanten einer zweiten Kantenlänge, die geringer als die erste Kantenlänge ist;
in mehreren Reihen angeordnete und zumindest im Wesentlichen rechteckige photovoltaische Zellen jeweils aufweisend zwei erste Zellenkanten einer ersten Zellenkantenlänge, die zumindest im Wesentlichen in eine zu den äußeren ersten Kanten parallele erste Richtung orientiert sind, und zwei zweite Zellenkanten einer zweiten Zellenkantenlänge, die geringer als die erste Zellenkantenlänge ist;
zwei Gruppen von jeweils zumindest im Wesentlichen in die erste Richtung orientierten Querverbindern, wobei die Querverbinder in jeder der zwei Gruppen in der ersten Richtung voneinander beabstandet sind, und die Querverbinder einer ersten Gruppe der zwei Gruppen in eine zur ersten Richtung senkrechten zweiten Richtung von den Querverbindern einer zweiten Gruppe der zwei Gruppen beabstandet sind;
jeweils typischerweise zumindest im Wesentlichen in die zweite Richtung orientierte Längsverbinderanordnungen, wobei jede der Längsverbinderanordnungen einen Querverbinder der ersten Gruppe mit den photovoltaischen Zellen einer der Reihen und einem Querverbinder der zweiten Gruppe elektrisch verbindet; und
zwei, in der Aufsicht zumindest bezüglich der ersten Richtung dezentral angeordnete Leistungsanschlüsse zum elektrischen Verbinden einer externen Last oder eines Wechselrichters mit den Querverbindern der ersten Gruppe.

Die zwei äußeren ersten Kanten und zwei äußeren zweiten Kanten können von Rahmenkanten eines in der Aufsicht zumindest im Wesentlichen rechteckigen äußeren Rahmens des Photovoltaikmodul oder von äußeren Kanten eines in der Aufsicht zumindest im Wesentlichen rechteckigen Trägers des Photovoltaikmoduls, z.B. eines Glasträgers oder Glassubstrats des Photovoltaikmoduls (auf dem die photovoltaische Zellen angeordnet sein können) gebildet werden.

Gemäß einem weiteren Ausführungsbeispiel weist ein Photovoltaikmodul in einer Aufsicht zwei äußere erste Kanten einer ersten Kantenlänge und zwei äußere zweite Kanten einer zweiten Kantenlänge, die geringer als die erste Kantenlänge ist, und die insbesondere von zwei ersten Rahmenkanten der ersten (Rahmen-) Kantenlänge und zwei zweiten Rahmenkanten der zweiten (Rahmen-) Kantenlänge eines Rahmens des Photovoltaikmoduls oder entsprechenden äußeren Kanten eines Trägers der Photovoltaikmoduls gebildet werden können, auf. Das Photovoltaikmodul weist in der Aufsicht in mehreren Reihen angeordnete und zumindest im Wesentlichen rechteckige photovoltaische Zellen mit jeweils zwei ersten Zellenkanten einer ersten Zellenkantenlänge, die zumindest im Wesentlichen in eine zu den ersten Kanten parallele erste Richtung (x) orientiert sind, und mit zwei zweiten Zellenkanten einer zweiten Zellenkantenlänge, die geringer als die erste Zellenkantenlänge ist, auf. Außerdem weist das Photovoltaikmodul eine erste Gruppe von Querverbindern und eine zweite Gruppe von Querverbindern auf, wobei die Querverbinder der ersten Gruppe von den Querverbindern der zweiten Gruppe in eine zur ersten Richtung senkrechten zweiten Richtung (y) beabstandet sind und jede der Reihen zumindest im Wesentlichen in die zweite Richtung orientiert ist. Das Photovoltaikmodul weist (in der Aufsicht) zudem eine Zellverbinderanordnung auf, durch die die photovoltaischen Zellen einer jeden Reihe (typischerweise paarweise) miteinander und mit einem der Querverbinder der ersten Gruppe und einem Querverbinder der zweiten Gruppe elektrisch verbunden sind.

Typischerweise weist das Photovoltaikmodul in der Aufsicht weiter zwei, in der Aufsicht zumindest bezüglich der ersten Richtung dezentral angeordnete Leistungsanschlüsse zum elektrischen Verbinden einer externen Last und/oder eines Umrichters mit jeweils zwei der Querverbinder der ersten Gruppe der Querverbinder auf.

Die Querverbinder in jeder der zwei Gruppen sind in der ersten Richtung typischerweise jeweils voneinander beabstandet.

Außerdem ist typischerweise zwischen benachbarten Querverbindern der ersten Gruppe jeweils eine Leistungsdiode geschaltet, insbesondere jeweils genau eine Leistungsdiode, wobei die Leistungsdioden typischerweise gleichsinnig in Reihe geschaltet sind.

Die Zellverbinderanordnung kann mehrere Zellverbinder(abschnitte), typischerweise eine Vielzahl von Zellverbinder(abschnitten) aufweisen, die reihenförmig bzw. gitterartig angeordnet sein können und/oder jeweils zwei benachbarte photovoltaische Zellen einer Reihe photovoltaischer Zellen miteinander oder eine jeweils (bzgl. der zweiten Richtung) äußere der photovoltaischen Zellen einer Reihe photovoltaischer Zellen mit einem der (benachbarten) Querverbinder elektrisch verbindet.

Dass eine Reihe (photovoltaischer Zellen) zumindest im Wesentlichen in die zweite Richtung orientiert ist, soll insbesondere beschreiben, dass die photovoltaischen Zellen der Reihe zumindest in der Aufsicht auf einer Linie angeordnet sind, die zumindest im Wesentlichen parallel zur zweiten Richtung ist, typischerweise parallel zur zweiten Richtung ist. Dabei können die photovoltaischen Zellen der Reihe zentriert bzgl. dieser Linie angeordnet sein.

Die vorliegende Erfindung wurde anhand von Ausführungsbeispielen erläutert. Diese Ausführungsbeispiele sollen keinesfalls als einschränkend für die vorliegende Erfindung verstanden werden. Insbesondere können einzelne Merkmale der verschiedenen Ausführungsbeispiele in andere Ausführungsformen übernommen werden oder verschiedene Ausführungsbeispiele miteinander kombiniert werden, solange sich die kombinierten Merkmale nicht technisch bedingt gegenseitig ausschließen.

### Bezugszeichenliste

- 1, 10: photovoltaische Zelle / Solarzelle
- 2: Mittelsteg von 5
- 5: elektrisches Verbindungssystem
- 11, 12: Zellenkanten, Kanten von 10
- 100, 200: Photovoltaikmodul / Solarmodul
- 51, 110, 210: Träger, Glas , Folie
- 111, 211: Rahmen
- 101, 102, 201, 202: Rahmenkanten / Kanten des Rahmens
- 120: Leitungsverbinderanordnung
- 121-125, 221-225: Querverbinder der Leitungsverbinderanordnung
- 114, 214, 324, 424, 525, 625, 735, 835: Zellverbinderanordnung / Längsverbinderanordnungen der Leitungsverbinderanordnung
- 500: Wechselrichter
- S, S', S₁-S₈: Zellensäule,-reihe
- A, A₁, A₂: Anschlussbereich
- D₁, D₂: Leistungsanschluss / Anschlussdose
- L₁, L₂: Leistungsdiode

## Patentansprüche

1. Photovoltaikmodul (100, 200), aufweisend:
- einen in einer Aufsicht zumindest im Wesentlichen rechteckigen äußeren Rahmen (111, 211), aufweisend zwei erste Rahmenkanten (101, 201) einer ersten Rahmenkantenlänge (L) und zwei zweite Rahmenkanten (102, 202) einer zweiten Rahmenkantenlänge (B), die geringer als die erste Rahmenkantenlänge ist (L);
- in der Aufsicht in mehreren Reihen (S₁-S₈) angeordnete und zumindest im Wesentlichen rechteckige photovoltaische Zellen (10) jeweils aufweisend zwei erste Zellenkanten (11) einer ersten Zellenkantenlänge (1), die zumindest im Wesentlichen in eine zu den ersten Rahmenkanten (101, 201) parallele erste Richtung (x) orientiert sind, und zwei zweite Zellenkanten (12) einer zweiten Zellenkantenlänge (b), die geringer als die erste Zellenkantenlänge (1) ist;
- zwei Gruppen von in der Aufsicht jeweils zumindest im Wesentlichen in die erste Richtung (x) orientierten Querverbindern (121-125, 221-225), wobei die Querverbinder (121-125, 221-225) in jeder der zwei Gruppen in der ersten Richtung (x) voneinander beabstandet sind, und die Querverbinder (121-123, 221-223) einer ersten Gruppe der zwei Gruppen in eine zur ersten Richtung (x) senkrechten zweiten Richtung (y) von den Querverbindern (124-125, 224-225) einer zweiten Gruppe der zwei Gruppen beabstandet sind;
- in der Aufsicht jeweils zumindest im Wesentlichen in die zweite Richtung (y) orientierte Längsverbinderanordnungen (114, 214, 324, 424, 425, 625, 735, 835), wobei jede der Längsverbinderanordnungen (114, 214, 324, 424, 425, 625, 735, 835) einen Querverbinder (121-123, 221-223) der ersten Gruppe mit den photovoltaischen Zellen (10) einer der Reihen (S₁ - S₈) und einem Querverbinder (124-125, 224-225) der zweiten Gruppe elektrisch verbindet; und
- zwei, in der Aufsicht zumindest bezüglich der ersten Richtung (x) dezentral angeordnete Leistungsanschlüsse (D1, D2) zum elektrischen Verbinden einer externen Last oder eines Wechselrichters (500) mit den Querverbindern (121-123) der ersten Gruppe.

2. Photovoltaikmodul (100, 200) nach Anspruch 1, wobei die erste Gruppe der Querverbinder einen ersten Querverbinder (121), einen zweiten Querverbinder (122), und einen dritten Querverbinder (123) aufweist, wobei die zweite Gruppe der Querverbinder einen vierten Querverbinder (124) und einen fünften Querverbinder (125) aufweist; und/oder aufweisend:
- zwei erste Längsverbinderanordnungen (114, 124), die jeweils die photovoltaischen Zellen (10) einer Reihe zweier erster Reihen (S₁, S₂) miteinander und mit dem ersten Querverbinder (121) und dem vierten Querverbinder (124) elektrisch verbinden;
- zwei zweite Längsverbinderanordnungen (324, 424), die jeweils die photovoltaischen Zellen (10) einer Reihe zweier zweiter Reihen (S₃, S₄) miteinander und mit dem zweiten Querverbinder (122) und dem vierten Querverbinder (124) elektrisch verbinden;
- zwei dritte Längsverbinderanordnungen (525, 625), die jeweils die photovoltaischen Zellen (10) einer Reihe zweier dritter Reihen (S₅, S₆) miteinander und mit dem zweiten Querverbinder (122) und dem fünften Querverbinder (125) verbinden; und
- zwei vierte Längsverbinderanordnungen (735, 835), die jeweils die photovoltaischen Zellen (10) einer Reihe zweier vierter Reihen (S₇, S₈) miteinander und mit dem dritten Querverbinder (123) und dem fünften Querverbinder (125) verbinden.

3. Photovoltaikmodul (100, 200) nach Anspruch 1 oder 2, wobei die photovoltaischen Zellen (10) jeder der Reihen (S₁ - S₈) in Reihe geschaltet sind, wobei jeder der Querverbinder (121-123, 221-223) der ersten Gruppe über k*N Längsverbinderanordnungen (114, 214, 324, 424, 425, 625, 735, 835) mit N Reihen (S₁ - S₈) der photovoltaischen Zellen (10) und einem Querverbinder (124-125, 224-225) der zweiten Gruppe elektrisch verbunden ist, wobei k eine positive ganze Zahl ist, die typischerweise in einem Bereich von 2 bis 35, noch typischer in einem Bereich von fünf bis fünfzehn liegt, wobei N eine ganze Zahl größer als eins, insbesondere zwei oder drei ist, wobei N erste Reihen (S₁, S₂) parallel geschaltet sind, wobei jede der Reihen (S₁ - S₈) m photovoltaische Zellen (10) aufweist, wobei m eine positive ganze Zahl ist, die typischerweise größer als fünf ist, wobei jede der Längsverbinderanordnungen (114, 214, 324, 424, 425, 625, 735, 835) m+1 Abschnitte aufweist, wobei N zweite Reihen (S₃, S₄) parallel geschaltet sind, wobei N dritte Reihen (S₅, S₄) parallel geschaltet, wobei N vierte Reihen (S₇, S₈) parallel geschaltet sind, und/oder wobei die photovoltaischen Zellen (10) der N ersten Reihen (S₁, S₂) in Reihe mit den photovoltaischen Zellen (10) der N zweiten Reihen (S₃, S₄), mit den photovoltaischen Zellen (10) der N dritten Reihen (S₅, S₆) und mit den photovoltaischen Zellen (10) der N vierten Reihen (S₇, S₈) in Reihe geschaltet sind.

4. Photovoltaikmodul (100, 200) nach einem der vorhergehenden Ansprüche, wobei die Querverbinder der ersten Gruppe, insbesondere der erste Querverbinder (121), der zweite Querverbinder (122), und der dritte Querverbinder (123) in der Aufsicht auf einer ersten Linie angeordnet sind, die zumindest im Wesentlichen parallel zur ersten Richtung (x) ist, wobei die Querverbinder der zweiten Gruppe, insbesondere der vierte Querverbinder (124) und der fünfte Querverbinder (125) in der Aufsicht auf einer zweiten Linie angeordnet sind, die zumindest im Wesentlichen parallel zur ersten Richtung (x) ist, wobei die erste Linie in der Aufsicht näher an einer ersten der zwei ersten Rahmenkanten (101, 201) des Rahmens (111, 211) als an einer Mittellinie zwischen den ersten Rahmenkanten (101, 201) des Rahmens (111, 211) liegt, wobei die zweite Linie in der Aufsicht näher an einer zweiten der zwei ersten Rahmenkanten (101, 201) des Rahmens (111, 211) als an der Mittellinie liegt, und/oder wobei die photovoltaischen Zellen (10) der Reihen (S₁-S₈) in der Aufsicht zwischen der ersten Linie und der zweiten Linie angeordnet sind.

5. Photovoltaikmodul (100, 200) nach einem der vorhergehenden Ansprüche, wobei die photovoltaischen Zellen (10) Halbzellen oder Drittelzellen sind.

6. Photovoltaikmodul (100, 200) nach Anspruch 5, wobei jede der Reihen (S₁ - S₈) sechs Halbzellen, typischerweise zehn Halbzellen, oder zehn Drittelzellen, typischerweise fünfzehn Drittelzellen aufweist, und/oder wobei jede der Reihen (S1 - S8) höchstens 15 Halbzellen oder höchstens 21 Drittelzellen aufweist.

7. Photovoltaikmodul (100, 200) nach einem der vorhergehenden Ansprüche, wobei die zwei ersten Rahmenkanten (101, 201) und die zwei zweiten Rahmenkanten (102, 202) des Rahmes (111, 211) eine Fläche von höchstens 3 m², typischerweise höchstens 2 m², noch typischer höchstens 1,98 m² umschließen, und/oder wobei ein Verhältnis zwischen der ersten Länge (L) der ersten Rahmenkanten (101, 201) und der zweiten Länge (B) der zweiten Rahmenkanten (102, 202) des Rahmens (111, 211) in einem Bereich von 1,5 bis 1,6 liegt.

8. Photovoltaikmodul (100, 200) nach einem der vorhergehenden Ansprüche, wobei ein Nennstrom des Photovoltaikmoduls (100, 200) in einem Bereich von 3 A bis 29 A oder sogar in einem Bereich von 3 A bis 13 A liegt, insbesondere etwa 12,5 A beträgt, wobei eine elektrische Nennleistung des Photovoltaikmoduls (100, 200) mindestens 380 W, mindestens 390 W oder sogar mindestens 400 W beträgt, und/oder wobei eine maximale flächenspezifische elektrische Leistungsdichte des Photovoltaikmoduls (100, 200) größer als 190 W/m², größer als 195 W/m² oder sogar größer als 200 W/m² ist, beispielsweise etwa 205 W/m² beträgt.

9. Photovoltaikmodul (100, 200) nach einem der vorhergehenden Ansprüche, wobei die Leistungsanschlüsse (D₁, D₂) als jeweilige Anschlussdose ausgeführt sind, und/oder für einen Rückstrom ausgelegt sind, der typischerweise zumindest doppelt so groß wie der Nennstrom des Photovoltaikmoduls (100, 200) ist.

10. Photovoltaikmodul (100, 200) nach einem der vorhergehenden Ansprüche, wobei ein erster Leistungsanschluss (D₁) der zwei Leistungsanschlüsse (D₁, D₂) in ohmscher Verbindung mit dem ersten Querverbinder (121) steht und mit dem zweiten Querverbinder (122) über eine erste Leistungsdiode (L₁) elektrisch verbunden ist, wobei ein zweiter Leistungsanschluss (D2) der zwei Leistungsanschlüsse (D₁, D₂) in ohmscher Verbindung mit dem dritten Querverbinder (123) steht und mit dem zweiten Querverbinder (122) über eine zweite Leistungsdiode (D2) elektrisch verbunden ist, und/oder wobei die erste Leistungsdiode (L₁) und die zweite Leistungsdiode (L₂) in Reihe geschaltet sind.

11. Photovoltaikmodul (100, 200) nach einem der vorhergehenden Ansprüche, wobei das Photovoltaikmodul (100, 200) keinen weiteren Leistungsanschluss zum elektrischen Verbinden mit der externen Last oder dem Wechselrichter (500) aufweist, und/oder wobei das Photovoltaikmodul (100, 200) keine weitere Leistungsdiode aufweist.

12. Photovoltaikmodul (100, 200) nach einem der vorhergehenden Ansprüche, wobei die zwei Leistungsanschlüsse (D1, D2) in der Aufsicht zumindest im Wesentlichen spiegelsymmetrisch zu einer in die zweiten Richtung (y) orientierten Mittellinie des Rahmens (111, 211) angeordnet sind, wobei die zwei Leistungsanschlüsse (D₁, D₂) in der Aufsicht bezüglich der zweiten Richtung (y) dezentral angeordnet sind, und/oder wobei die zwei Leistungsanschlüsse (D₁, D₂) in einem Randbereich der mehreren Reihen (S₁-S₈), nahe einer der zwei erste Rahmenkanten (101, 201) des Rahmens (111, 211), und/oder in der Aufsicht benachbart oder sogar auf einer zur ersten Richtung (x) parallelen Linie angeordnet sind.

13. Photovoltaikanlage (1000), aufweisend ein Photovoltaikmodul (100, 200) nach einem der vorhergehenden Ansprüche.

14. Photovoltaikanlage (1000) nach Anspruch 13, weiter aufweisend einen Wechselrichter (500), der mit dem ersten Leistungsanschluss (D₁) und dem zweiten Leistungsanschluss (D₂) verbindbar ist, oder einen elektrischen Energiespeicher, der mit dem ersten Leistungsanschluss (D₁) und dem zweiten Leistungsanschluss (D₂) verbindbar ist.

15. Set zum Aufbau einer Photovoltaikanlage (1000), insbesondere zur Ausrüstung eines Dachs mit der Photovoltaikanlage (1000), wobei das Set ein Photovoltaikmodul (100, 200) nach einem der Ansprüche 1 bis 12 aufweist.
